(19) Europäisches Patentamt
European Patent Office
Office européen des brevets

(11) **EP 3 144 987 B1**

(12) **EUROPEAN PATENT SPECIFICATION**

(45) Date of publication and mention
of the grant of the patent:
**12.12.2018 Bulletin 2018/50**

(21) Application number: **15792322.8**

(22) Date of filing: **27.04.2015**

(51) Int Cl.:
*H01L 41/187* (2006.01)

(86) International application number:
**PCT/JP2015/062720**

(87) International publication number:
**WO 2015/174265 (19.11.2015 Gazette 2015/46)**

(54) **FERROELECTRIC THIN FILM, SUBSTRATE WITH PIEZOELECTRIC THIN FILM, PIEZOELECTRIC ACTUATOR, INKJET HEAD, AND INKJET PRINTER**

FERROELEKTRISCHE DÜNNSCHICHT, SUBSTRAT MIT PIEZOELEKTRISCHER DÜNNSCHICHT, PIEZOELEKTRISCHER AKTOR, TINTENSTRAHLKOPF UND TINTENSTRAHLDRUCKER

FILM MINCE FERROÉLECTRIQUE, SUBSTRAT COMPRENANT UN FILM MINCE PIÉZOÉLECTRIQUE, ACTIONNEUR PIÉZOÉLECTRIQUE, TÊTE DE JET D'ENCRE, ET IMPRIMANTE À JET D'ENCRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.05.2014 JP 2014101152**

(43) Date of publication of application:
**22.03.2017 Bulletin 2017/12**

(73) Proprietor: **Konica Minolta, Inc.**
**Tokyo 100-7015 (JP)**

(72) Inventor: **MAWATARI Kenji**
**Tokyo 100-7015 (JP)**

(74) Representative: **Henkel, Breuer & Partner**
**Patentanwälte**
**Maximiliansplatz 21**
**80333 München (DE)**

(56) References cited:
**JP-A- 2008 258 575      JP-A- 2009 252 786**
**JP-A- 2012 009 677      JP-A- 2013 229 510**
**US-A1- 2005 146 249      US-A1- 2010 079 555**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical Field**

The present invention relates to a ferroelectric thin film formed of lead niobate titanate zirconate, a piezoelectric thin film-coated substrate (a substrate with a piezoelectric thin film) provided with such a ferroelectric thin film, a piezoelectric actuator, an inkjet head, and an inkjet printer.

**Background Art**

Conventionally, piezoelectric substances such as lead zirconate titanate (PZT) are used for electromechanical transducers such as drivers and sensors. On the other hand, to meet the recent demand for smaller size, higher density, lower cost, etc. in devices, MEMS (micro-electro-mechanical systems) elements employing silicon (Si) substrates are increasing. To apply a piezoelectric substance to a MEMS element, it is preferable that the piezoelectric substance be formed into a thin film. Forming a piezoelectric substance into a thin film makes possible high-precision processing using semiconductor processing technologies such as film deposition and photolithography, and helps achieve smaller size and higher density. Moreover, a number of elements can then be processed at once on a large-area wafer, and this helps reduce cost. Furthermore, improved electromechanical conversion efficiency brings advantages such as improved characteristics of drivers and improved sensitivity of sensors.

As one example of devices to which such MEMS are applied, inkjet printers are known. In an inkjet printer, while an inkjet head having a plurality of channels through which to eject liquid ink is moved relative to a recording medium such as a sheet of paper or cloth, the ejection of the ink is controlled in such a way that a two-dimensional image is formed on the recording medium.

The ejection of ink can be achieved by use of a pressure actuator (piezoelectric, electrostatic, thermal-deformation, etc.), or by producing bubbles in the ink inside a pipe with heat. Among others, piezoelectric actuators are frequently used today for their advantages such as high output, capability to be modulated, quick response, and no preference for particular types of ink. In particular, to build a compact, low-cost printer with high resolution (operating with fine ink droplets), an inkjet head employing a thin film of a piezoelectric substance is suitably used.

In addition, inkjet printers are nowadays required to form images at increasingly high speeds, with increasingly definition. To meet the requirements, inkjet heads are required to be capable of ejecting ink with high viscosity of 10 cp (0.01 Pa•s) or more. To achieve ejection of high-viscosity ink, a piezoelectric thin film (ferroelectric thin film) has to have a high piezoelectric property (piezoelectric constant $d_{31}$) and a high displacement generating power (film thickness of 1 $\mu$m or more).

On the other hand, as processes for depositing a film of a piezoelectric substance such as PZT on a substrate such as of silicon, there are known chemical film deposition processes such as a CVD (chemical vapor deposition) process; physical processes such as a sputtering process and an ion-plating process; and liquid-phase growth processes such as a sol-gel process. The upper limit of the film thickness obtained by these processes is about 10 $\mu$m. A larger thickness is prone to develop cracks and exfoliation, and does not yield the desired property.

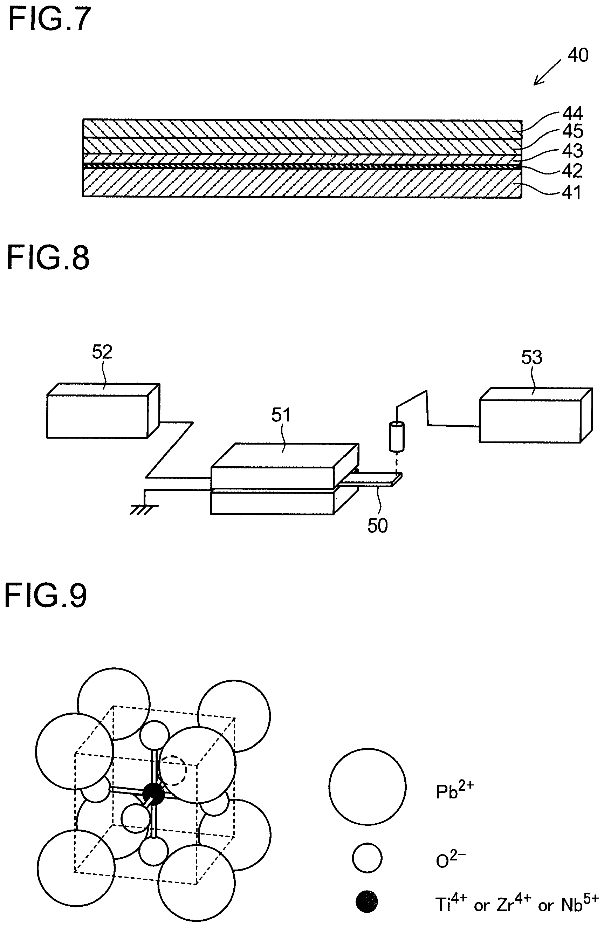

A deposited film of PZT exerts a satisfactory piezoelectric effect when it has a perovskite structure as shown in Fig. 9. A perovskite structure is a structure that ideally has a unit lattice of a cubic crystal system and that is of an $ABO_3$ type composed of metal A located at every vertex of the cubic crystal, metal B located at the body center of the cubic crystal, and oxygen O located at every face center of the cubic crystal. It is assumed that crystals having a perovskite structure include, as distorted forms of a cubic crystal, tetragonal crystals, rhombic crystals, rhombohedral crystals, and the like.

A thin film of PZT deposited on an electrode on a Si substrate is, due to a difference in lattice constant from the crystal of the electrode, a polycrystal, meaning that it is a congregate of a plurality of crystals. The polycrystal can be, depending on the fabrication process, a congregate of crystals in the form of particles (particulate crystals) with a particle diameter of several hundred nanometers, or a congregate of columnar crystals which are single elongate crystal particles in the film thickness direction with a width of several hundred nanometers. As for columnar crystals, it is known that, the larger the number of crystals that have grown with the same crystal face in the film thickness direction (the higher the degree of orientation), the higher the piezoelectric property of the film.

One way of improving the piezoelectric property is to add an impurity to a piezoelectric substance to make non-180° polarization rotation more likely to occur and thereby improve the relative dielectric constant and the piezoelectric property. In particular, it is known that a substance called PNZT, which is obtained by substituting, in a piezoelectric substance having a perovskite structure of an $ABO_3$ type as shown in Fig. 9, the zirconium (Zr) or titanium (Ti) located at site B with niobium (Nb), which has a valence higher by one than those, has a higher relative dielectric constant and a higher piezoelectric property than PZT having no Nb added to it.

Here, in bulk ceramics, the amount of Nb added is about several percent by mol ratio, and an attempt to add more resulted, due to a difference in valence from the original PZT, in failure of proper sintering and thus failure to obtain a piezoelectric element. However, in recent years, it has been emerging that forming PNZT into a thin film makes it possible to add a large amount, such as over 10% by mol, of Nb. For example, Patent Document 1 teaches that, when a film of PNZT is deposited by a sol-gel process, adding a sintering additive such as Si along with Nb makes it possible to add 10% or more by mol of Nb.

However, it has been found that, even though adding a sintering additive helps increase the amount of Nb added, it does not help improve the piezoelectric property, and thus it is not suitable for actuators. Accordingly, for example, in Patent Document 2, a film of PNZT is deposited in a state of non-equilibrium by sputtering so that 10% or more by mol of Nb can be added without the use of a sintering additive. Moreover, Patent Document 2 teaches that, when PNZT is expressed by $Pb_{1+\delta}(Zr_{0.52}Ti_{0.48})_{1-y}Nb_y]O_z$, with $1 + \delta = 1.02$ to $1.10$, $y = 0.1$ to $0.25$, and $2 < z \leq 3$, a PNZT film with excellent ferroelectricity is obtained, and that, with the composition $Pb_{1.12}Zr_{0.43}Ti_{0.44}Nb_{0.13}O_3$, a high piezoelectric constant $d_{31}$ is obtained.

Furthermore, Patent Document 3 teaches that, by controlling, out of the film deposition parameters for sputtering, the film deposition temperature and the target-to-substrate distance in proper ranges, it is possible to obtain a PNZT film having a high piezoelectric property with a piezoelectric constant $d_{31} = -250$ [pm/V] for use in actuators.

### List of Citations

### Patent Literature

Patent Document 1: Japanese Patent Application Publication No. 2005-072474 (see claims 1 to 3, paragraphs [0026], etc.)
Patent Document 2: Japanese Patent Application Publication No. 2008-270704 (see claim 1, paragraphs [0010], [0011], [0014], [0022], [0023], [0085] to [0092], and [0102], etc.)
Patent Document 3: Japanese Patent Application Publication No. 2008-081802 (see claims 1, 6, and 7, paragraphs [0007], [0026], [0027], and [0086] to [0093], etc.) Reference is likewise made to the prior art documents US2010079555, US2005146249, and JP2012009677.

### Summary of the Invention

### Technical Problem

However, Patent Document 2 teaches, as specific ratios of Zr (or Ti) in the PNZT film, only two sets, namely Zr/Ti = 0.52/0.48 and Zr/Ti = 0.43/0.44, and gives no consideration to a specific range of the Zr ratio that yields a high piezoelectric property. Patent Document 3 merely teaches that a film of Nb-doped PZT is deposited by use of $Pb_{1.3}Zr_{0.52}Ti_{0.48}O_3$ as a target, and that, in the deposited film of PNZT, Pb / (Zr + Ti + Nb) = 1.02, and teaches nothing about a specific composition of (specific mol ratios of elements in) or proper ranges of composition ratios in a PNZT film that yields a high piezoelectric property with $d_{31} = -250$ [pm/V].

In particular, it is known that the Zr ratio in a PNZT film affects not only the piezoelectric property but also the withstand voltage. Accordingly, also from the viewpoint of improving durability, it is desirable to properly set the range of the Zr ratio in a PNZT film.

If the film stress of a PNZT thin film is too low, the optimum composition is close to that in bulk where no stress is applied, and this makes it difficult to obtain a high piezoelectric property with a composition unique to a thin film. On the other hand, if the film stress is too high, the film may develop a crack, or be prone to exfoliate when the film is formed on a substrate, and this makes it difficult to obtain a high piezoelectric property. Accordingly, to achieve a high piezoelectric property without developing a crack or the like with a composition unique to a thin film, it is necessary to define the film stress as necessary. In this respect, Patent Document 2 teaches nothing about film stress. Patent Document 3 does mention stress in a temperature-decreasing process during or after film deposition, but makes no mention of controlling film stress to obtain a high piezoelectric property with a composition unique to a thin film.

Devised to solve the problems mentioned above, the present invention aims to provide a ferroelectric thin film that achieves a high piezoelectric property with a composition unique to a thin film of PNZT as a result of the ranges of composition ratios of the PNZT being defined properly and, as necessary, the range of film stress being defined properly and that has an improved withstand voltage and hence improved durability, a piezoelectric thin film-coated substrate provided with such a ferroelectric thin film, a piezoelectric actuator, an inkjet head, and an inkjet printer.

**Means for Solving the Problem**

The current invention is directed to a ferroelectric film comprising lead niobate titanate zirconate according to the independent device claim 1.

According to one aspect of the present invention, a ferroelectric thin film is formed of lead niobate titanate zirconate. Here, the ratio "a" of lead to the sum of zirconium, titanium, and niobium is 100% or more by mol ratio, the ratio "b" of niobium to the sum of zirconium, titanium, and niobium is 10% or more but 20% or less by mol ratio, the ratio "c" of zirconium to the sum of zirconium and titanium is 52% or more but 59% or less by mol ratio, and the film stress is 100 MPa or more but 250 MPa or less.

According to another aspect of the present invention, a ferroelectric thin film is formed of lead niobate titanate zirconate. Here, the ratio "a" of lead to the sum of zirconium, titanium, and niobium is 100% or more but 105% or less by mol ratio, the ratio "b" of niobium to the sum of zirconium, titanium, and niobium is 10% or more but 20% or less by mol ratio, and the ratio "c" of zirconium to the sum of zirconium and titanium is 54% or more but 59% or less by mol ratio.

**Advantageous Effects of the Invention**

By properly defining the ranges of the composition ratios (ratios "a" to "c") of a PNZT thin film and, as necessary, the range of the film stress, it is possible to achieve a high piezoelectric property with a composition unique to the thin film of PNZT. and to improve the withstand voltage and hence the durability of the PNZT.

**Brief Description of Drawings**

Fig. 1 is an illustrative diagram showing an outline configuration of an inkjet printer;
Fig. 2A is a plan view showing an outline configuration of an actuator of an inkjet head provided in the inkjet printer;
Fig. 2B is a sectional view along line A-A' in the plan view in Fig. 2A as seen from the direction indicated by the arrows;
Fig. 3 is a sectional view of the inkjet head;
Fig. 4 is a series of sectional views showing a fabrication procedure of the inkjet head;
Fig. 5 is a sectional view showing another configuration of the inkjet head;
Fig. 6 is a series of sectional views showing a fabrication procedure of a piezoelectric thin film-coated substrate having a piezoelectric thin film deposited on a substrate,
Fig. 7 is a sectional view of the piezoelectric thin film-coated substrate having a seed layer;
Fig. 8 is a perspective view showing an outline configuration of a piezoelectric displacement tester; and
Fig. 9 is an illustrative diagram schematically showing a crystal structure of a piezoelectric substance.

**Description**

The present invention will be described below with reference to the accompanying drawings. In the present description, any range of values from the value A to the value B is assumed to include the lower limit A and the upper limit B.

[Configuration of an Inkjet Printer]

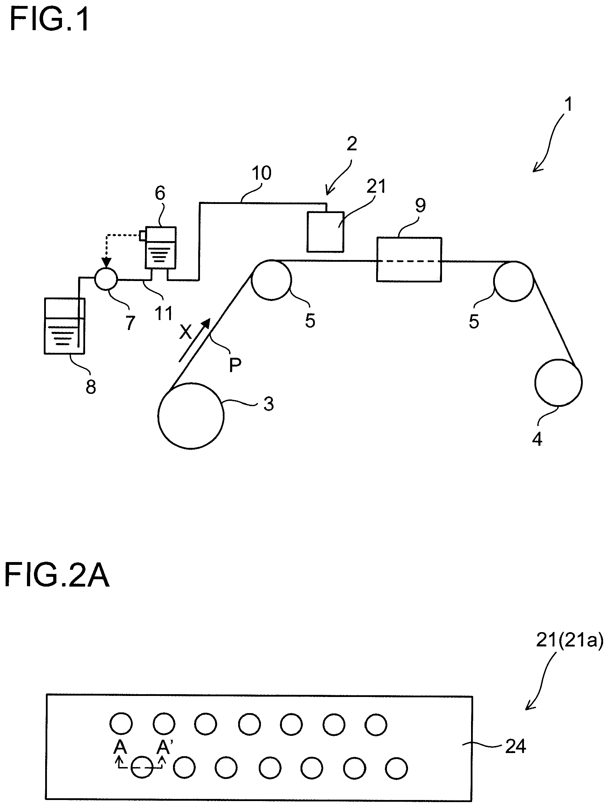

Fig. 1 is an illustrative diagram showing an outline configuration of an inkjet printer 1. The inkjet printer 1 is a so-called line head-type inkjet recording apparatus that has an inkjet head section 2 in which an inkjet head 21 is disposed in the shape of a line in the width direction of a recording medium.

The inkjet printer 1 includes, in addition to the inkjet head section 2 mentioned above, a feed-out roll 3, a wind-up roll 4, two back rolls 5, a middle tank 6, a feed pump 7, a reservoir 8, and a fixing mechanism 9.

The inkjet head section 2 ejects ink from the inkjet head 21 onto a recording medium P to perform image formation (printing) based on image data, and is arranged near one of the back rolls 5. The inkjet head 21 will be described in detail later.

The feed-out roll 3, the wind-up roll 4, and the back rolls 5 are each a member in a cylindrical shape that is rotatable about its axis. The feed-out roll 3 is a roll that feeds out a recording medium P, which is wound up a number of turns around the circumferential face of the feed-out roll 3, toward a position opposite the inkjet head section 2. The feed-out roll 3, by being rotated by an unillustrated driving means such as a motor, feeds out the recording medium P and transports it in direction X in Fig. 1.

The wind-up roll 4 winds up, around its circumferential face, the recording medium P that has been fed out from the feed-out roll 3 and has ink ejected onto it by the inkjet head section 2.

The back rolls 5 are arranged between the feed-out roll 3 and the wind-up roll 4. Of the back rolls 5, the one located on the upstream side with respect to the transport direction of the recording medium P transports the recording medium P fed out from the feed-out roll 3 toward the position opposite the inkjet head section 2 while supporting the recording medium P in a form sustained on part of the circumferential face of the back roll 5. The other back roll 5 transports the recording medium P from the position opposite the inkjet head section 2 toward the wind-up roll 4 while supporting the recording medium P in a form sustained on part of the circumferential face of the back roll 5.

The middle tank 6 temporarily stores ink fed from the reservoir 8. The middle tank 6 is connected to a plurality of ink tubes 10, and feeds the inkjet head 21 with ink while adjusting the back pressure of ink in the inkjet head 21.

The feed pump 7 feeds the ink stored in the reservoir 8 to the middle tank 6, and is arranged in the middle of a feed pipe 11. The ink stored in the reservoir 8 is drawn by the feed pump 7, and is fed through the feed pipe 11 to the middle tank 6.

The fixing mechanism 9 fixes to the recording medium P the ink ejected onto the recording medium P by the inkjet head section 2. The fixing mechanism 9 comprises a heater for fixing the ejected ink to the recording medium P by heat, a UV lamp that cures the ejected ink by irradiating it with UV radiation (ultraviolet rays), or the like.

In the configuration described above, the recording medium P fed out from the feed-out roll 3 is transported by the back roll 5 to a position opposite the inkjet head section 2, where ink is ejected from the inkjet head section 2 onto the recording medium P. Then, the ink ejected onto the recording medium P is fixed by the fixing mechanism 9, and the recording medium P having the ink fixed to it is wound up by the wind-up roll 4. In this way, in the line head-type inkjet printer 1, while the inkjet head section 2 is kept stationary, the recording medium P is transported and meanwhile ink is ejected to form an image on the recording medium P.

The inkjet printer 1 may instead be configured to form an image on a recording medium by a serial head method. A serial head method is a method in which, while a recording medium is transported, an inkjet head is moved in the direction perpendicular to its transport direction and meanwhile ink is ejected to form an image.

[Configuration of an Inkjet Head]

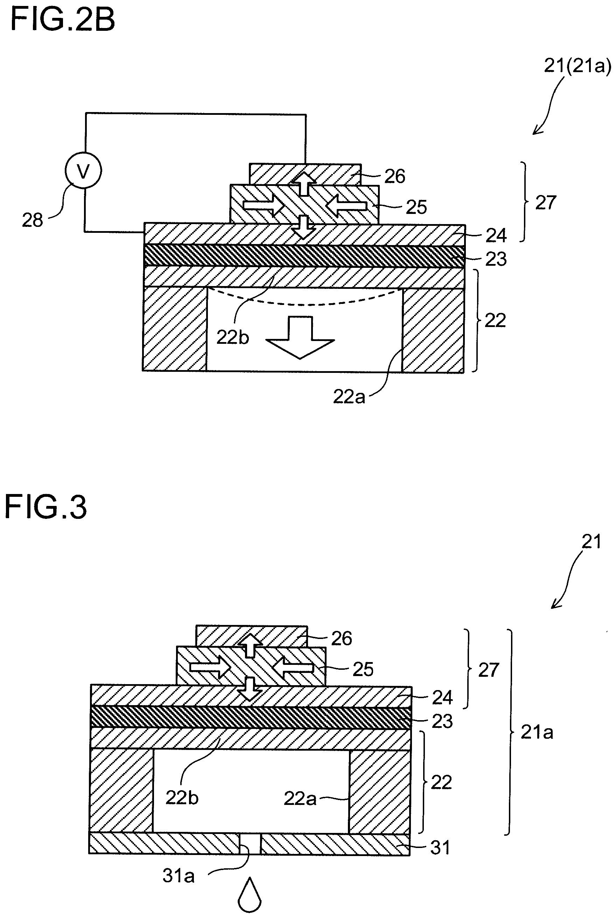

Next, the configuration of the inkjet head 21 mentioned above will be described. Fig. 2A is a plan view showing an outline configuration of an actuator 21a (a piezoelectric thin film-coated substrate, a piezoelectric actuator) of the inkjet head 21, and Fig. 2B is a sectional view along line A-A' in the plan view as seen from the direction indicated by the arrows. Fig. 3 is a sectional view of the inkjet head 21, which is built by bonding a nozzle substrate 31 to the actuator 21a in Fig. 2B.

The inkjet head 21 has a thermally-oxidized film 23, a lower electrode 24, a piezoelectric thin film 25, and an upper electrode 26 in this order on a substrate 22 having a plurality of pressure chambers 22a (cavities).

The substrate 22 comprises a semiconductor substrate formed of single-crystal Si (silicon) alone, or a SOI (silicon on insulator) substrate, in either case with a thickness of, for example, about 300 to 750 $\mu$m. Fig. 2B shows a case where the substrate 22 comprises a SOI substrate. The SOI substrate is composed of two Si substrates bonded together via an oxide film. The upper wall of the pressure chamber 22a in the substrate 22 (the wall located on that side of the pressure chamber 22a where the piezoelectric thin film is formed) constitutes a diaphragm 22b that serves as a driven membrane, and is displaced (vibrates) as the piezoelectric thin film 25 is driven (expands and contracts) so as to apply a pressure to the ink inside the pressure chamber 22a.

The thermally-oxidized film 23 is formed of $SiO_2$ (silicon oxide) with a thickness of, for example, about 0.1 $\mu$m, and is formed for the purposes of protecting and electrically insulating the substrate 22.

The lower electrode 24 is a common electrode disposed to be common to the plurality of pressure cavities 22a, and is composed of a Ti (titanium) layer and a Pt (platinum) layer stacked together. The Ti layer is formed to improve adhesion between the thermally-oxidized film 23 and the Pt layer. The Ti layer has a thickness of, for example, about 0.02 $\mu$m, and the Pt layer has a thickness of, for example, about 0.1 $\mu$m.

The piezoelectric thin film 25 comprises a ferroelectric thin film formed of, for example, PNZT (lead niobate titanate zirconate), which is PZT having Nb (niobium) added to it, and is disposed one for each of the pressure chambers 22a. The piezoelectric thin film 25 has a film thickness of, for example, 1 $\mu$m or more but 10 $\mu$m or less.

In the PNZT of which the piezoelectric thin film 25 is formed, the ratio "a" of Pb (lead) to the sum of Zr (zirconium), Ti, and Nb is 100% or more by mol ratio, the ratio "b" of Nb to the sum of Zr, Ti, and Nb is 10% or more but 20% or less by mol ratio, the ratio "c" of Zr to the sum of Zr and Ti is 52% or more but 59% or less by mol ratio, and the film stress is 100 MPa or more but 250 MPa or less. Alternatively, in the PNZT, the ratio "a" is 100% or more but 105% or less by mol ratio, the ratio "b" is 10% or more but 20% or less by mol ratio, and the ratio "c" is 54% or more but 59% or less by mol ratio.

In other words, when the composition of the PNZT is expressed by $Pb_{1+\delta}[(Zr_xTi_{1-x})_{1-y}Nb_y]O_3$, either

$$\delta \geq 0,$$

$$0.10 \leq y \leq 0.20,$$

$$0.52 \leq x \leq 0.59,$$

and
the film stress is 100 MPa or more but 250 MPa or less,
or

$$0 \leq \delta \leq 0.05,$$

$$0.10 \leq y \leq 0.20,$$

and

$$0.54 \leq x \leq 0.59.$$

By defining the composition ratios of PNZT and, as necessary, the film stress in this way, it is possible to obtain PNZT with a high piezoelectric property and to improve the withstand voltage. How this is achieved will be described in detail later by way of practical examples.

The upper electrode 26 is an individual electrode that is provided one for each of the pressure chambers 22a, and is composed of a Ti layer and a Pt layer stacked together. The Ti layer is formed to improve the adhesion between the piezoelectric thin film 25 and the Pt layer. The Ti layer has a thickness of, for example, about 0.02 $\mu$m, and the Pt layer has a thickness of, for example, about 0.1 to 0.2 $\mu$m. The upper electrode 26 is disposed so as to hold the piezoelectric thin film 25 between itself and the lower electrode 24 from the film thickness direction. Instead of the Pt layer, a layer of gold (Au) may be formed.

The lower electrode 24, the piezoelectric thin film 25, and the upper electrode 26 constitute a thin-film piezoelectric element 27 for ejecting the ink inside the pressure chamber 22a to outside. The thin-film piezoelectric element 27 is driven based on a voltage (driving signal) that is applied from a drive circuit 28 to the lower and upper electrodes 24 and 26. The inkjet head 21 is formed by arraying thin-film piezoelectric elements 27 and pressure chambers 22a longitudinally and laterally.

On that side of the pressure chamber 22a opposite from the diaphragm 22b, a nozzle substrate 31 is bonded. In the nozzle substrate 31, ejection orifices (nozzle orifices) 31a through which to eject the ink stored in the pressure chamber 22a to outside as ink droplets. The pressure chamber 22a stores ink that is fed from the middle tank 6.

In the configuration described above, when a voltage is applied from the drive circuit 28 to the lower and upper electrodes 24 and 26, according to the potential difference between the lower and upper electrodes 24 and 26, the piezoelectric thin film 25 expands or contracts in the direction perpendicular to the thickness direction (the direction parallel to the plane of the substrate 22). The resulting difference in length between the piezoelectric thin film 25 and the diaphragm 22b produces a curvature in the diaphragm 22b, and thus the diaphragm 22b is displaced (warps, vibrates) in the thickness direction.

Thus, with ink stored inside the pressure chamber 22a, as the diaphragm 22b vibrates as mentioned above, a pressure wave is propagated to the ink inside the pressure chamber 22a, and thus the ink inside the pressure chamber 22a is ejected to outside through the ejection orifice 31a as ink droplets.

With the inkjet head 21a,
as will be described later, the piezoelectric thin film 25 of the actuator 21a has such a high piezoelectric property that ink ejection is possible with high-viscosity ink, and thus it is possible to build an inkjet printer 1 that is advantageous to high-speed, high-definition printing.

In the actuator 21a (piezoelectric thin film-coated substrate) described above, the upper electrode 26 is formed separately on that side of the piezoelectric thin film 25 opposite from the lower electrode 24, and thus the piezoelectric thin film 25 can be expanded and contracted reliably according to the applied voltage.

[Method for Fabricating an Inkjet Head]

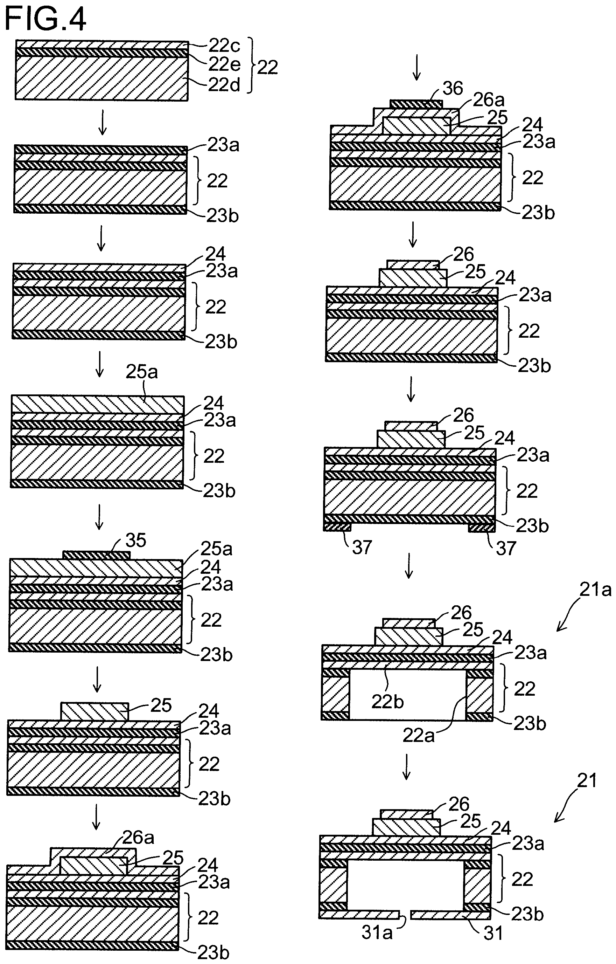

Next, a method for fabricating the inkjet head 21 will be described. Fig. 4 is a series of sectional views showing a fabrication procedure of the inkjet head 21.

First, a substrate 22 is prepared. For the substrate 22, crystalline silicon (Si) can be used, which is frequently used in MEMS (micro-electro-mechanical systems), and used here is a substrate with an SOI structure composed of two Si substrates 22c and 22d bonded together via an oxide film 22e.

The substrate 22 is put in a heating furnace, and while it is kept at about 1500 °C for a predetermined length of time, thermally-oxidized films 23a and 23b of $SiO_2$ are formed on the surfaces of the substrates 22c and 22d respectively. Next, on one thermally-oxidized film 23a, a layer of Ti and a layer of Pt are deposited in this order by sputtering to form a lower electrode 24.

Subsequently, the substrate 22 is heated again to about 600 °C, and a layer 25a of PNZT to serve as a displaced film is deposited by sputtering. Next, the substrate 22 is coated with a photosensitive resin 35 by spin-coating, and is subjected, via a mask, to light-exposure and etching to remove unnecessary parts of the photosensitive resin 35 so that the shape of a piezoelectric thin film 25 to be formed is transferred. Then, with the photosensitive resin 35 as a mask, the shape of the layer 25a is trimmed by reactive ion-etching to form the piezoelectric thin film 25.

Next, on the lower electrode 24, so as to cover the piezoelectric thin film 25, a layer of Ti and a layer of Pt are deposited in this order by sputtering to form a layer 26a. Subsequently, the layer 26a is coated with a photosensitive resin 36, and is subjected, via a mask, to light-exposure and etching to remove unnecessary parts of the photosensitive resin 36 so that the shape of an upper electrode 26 to be formed is transferred. Then, with the photosensitive resin 36 as a mask, the shape of the layer 26a is trimmed by reactive ion-etching to form the upper electrode 26.

Next, the reverse side of the substrate 22 (the side facing the thermally-oxidized film 23b) is coated with a photosensitive resin 37 by spin-coating, and is subjected, via a mask, to light-exposure and etching to remove unnecessary parts of the photosensitive resin 37 so that the shape of the pressure chamber 22a to be formed is transferred. Then, with the photosensitive resin 37 as a mask, the substrate 22 is removed by reactive ion-etching to form the pressure chamber 22a, thereby to form the actuator 21a.

Then, the substrate 22 of the actuator 21a and a nozzle substrate 31 having an ejection orifice 31a are bonded together with adhesive or the like. Now, the inkjet head 21 is complete. A middle glass substrate having through-holes at positions corresponding to the ejection orifices 31a may be used, in which case, after the thermally-oxidized film 23b is removed, the substrate 22 and the middle glass substrate, and the middle glass substrate and the nozzle substrate 31, can be bonded together by anodic bonding. In this case, the three components (the substrate 22, the middle glass substrate, and the nozzle substrate 31) can be bonded together without use of adhesive.

The electrode material for the lower electrode 24 is not limited to Pt mentioned above. Other examples include metals and metal oxides such as Au (gold), Ir (iridium), $IrO_2$ (iridium oxide), $RuO_2$ (ruthenium oxide), $LaNiO_3$ (lanthanum nickelate), and $SrRuO_3$ (strontium ruthenate), and combinations of these.

[Another Configuration of an Inkjet Head]

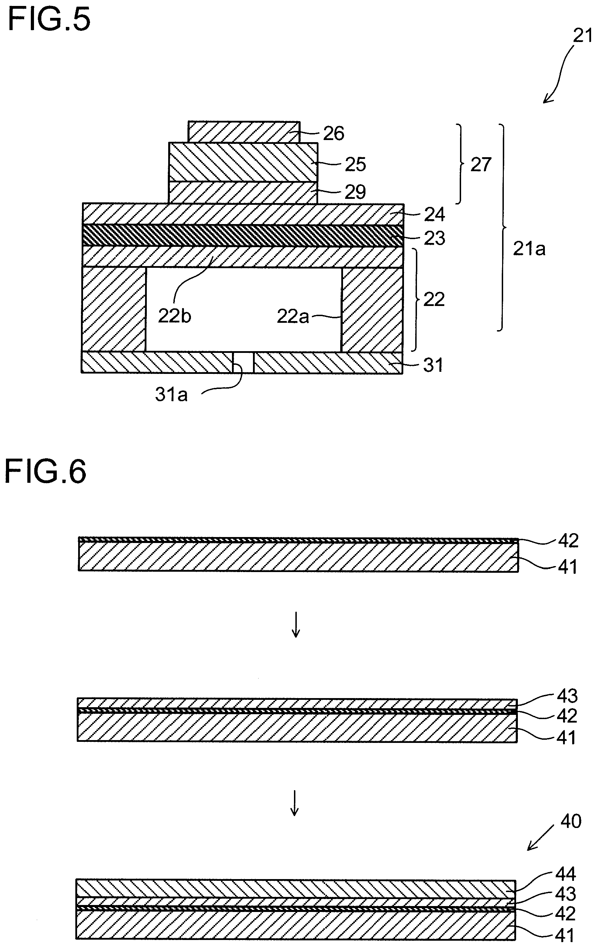

Fig. 5 is a sectional view showing another configuration of the inkjet head 21. As shown there, a seed layer 29 may be disposed between the lower electrode 24 and the piezoelectric thin film 25. The seed layer 29 is an orientation control layer for controlling the crystalline orientation of the piezoelectric thin film 25. The seed layer 29 is formed of, for example, PLT (lead lanthanum titanate), and may instead be formed of $LaNiO_3$ or $SrRuO_3$.

[Practical Examples]

Next, specific examples of the composition ratios of PNZT that forms a piezoelectric thin film will be described, along with a method for fabricating a piezoelectric thin film, by way of practical examples. For comparison with those practical examples, comparative example will also be described. Fig. 6 is a series of sectional views showing a fabrication procedure of a piezoelectric thin film-coated substrate that has a piezoelectric thin film deposited as an upper layer relative to a substrate.

(Practical Example 1)

First, on a substrate 41 which is a single-crystal Si wafer with a thickness of about 400 $\mu$m, a thermally-oxidized film 42 was formed with a thickness of about 100 nm. The wafer can be of standard dimensions, such as with a thickness of 300 $\mu$m to 725 $\mu$m and a diameter of 3 inches to 8 inches. The thermally-oxidized film 42 can be formed by exposing the Si wafer to high temperature of about 1200 °C in an atmosphere of oxygen in a wet oxidation furnace. The substrate 41 and the thermally-oxidized film 42 correspond to, in Fig. 2, the substrate 22 and the thermally-oxidized film 23 respectively.

Next, on the thermally-oxidized film-coated Si substrate, by sputtering, a Ti layer with a thickness of about 10 nm was formed as an adhesion layer, and further on, a Pt layer with a thickness of about 150 nm was formed to form a lower electrode 43. Here, Ti was sputtered under the following conditions: Ar flow rate, 20 sccm; pressure, 0.9 Pa; RF power applied to the target, 100 W; and substrate temperature, 400 °C. On the other hand, Pt was sputtered under the following conditions: Ar flow rate, 20 sccm; pressure, 0.8 Pa; RF power applied to the target, 150 W; and substrate temperature, 400 °C. The lower electrode 43 corresponds to the lower electrode 24 in Fig. 2B.

The film deposition of Ti and Pt was preformed on a dual sputtering machine having two targets, namely Ti and Pt, inside a chamber. In this way, it is possible to form the stack structure of a Pt/Ti/Si substrate continuously without ever getting out of vacuum.

The Ti layer as an adhesion layer, when exposed to high temperature in a post-process (such as formation of a PNZT layer), may cause Ti to diffuse in the Pt layer to form hillocks on the surface of the Pt layer, leading to defects such as drive current leakage and degraded orientation in the PNZT film. To prevent such defects, the adhesion layer may be formed of TiOx instead of Ti. TiOx can be formed by reactive sputtering in which oxygen is introduced while Ti is sputtered, or can be formed by depositing a film of Ti and then heating it at about 700 °C in the atmosphere of oxygen in an RTA (rapid thermal annealing) furnace.

Subsequently, by use of a sputtering machine, a film of PNZT was deposited with a thickness of about 4 $\mu$m on the Pt to form a piezoelectric thin film 44 formed of PNZT. In this way, a piezoelectric thin film-coated substrate 40 having the piezoelectric thin film 44 formed as an upper layer relative to the substrate 41 was formed. The piezoelectric thin film 44 corresponds to the piezoelectric thin film 25 in Fig. 2B. PNZT was sputtered under the following conditions: Ar flow rate, 20 sccm; $O_2$ flow rate, 0.6 sccm; pressure, 0.5 Pa, substrate temperature, 600 °C; RF power applied to the target, 500 W.

Used as the target for sputtering was one with a Zr/Ti ratio of 57/43 by mol ratio, having 10% by mol of Nb added to it. The Pb contained in the target tends to re-evaporate during film deposition at high temperature, and the formed thin film tends to be short of Pb; thus slightly more Pb needs to be added than the stoichiometric ratio in a perovskite crystal. It is preferable that the amount of Pb in the target be increased by 10 to 30% compared with the stoichiometric ratio, though it depends on film deposition temperature.

The deposited PNZT film was inspected by X-ray diffraction (XRD), and it was found that the film's crystal structure was pseudo-cubic, and that the film's degree of (100) orientation was 90%. A (100) orientation denotes a perovskite crystal orientation, and encompasses not only an orientation in which the polarization direction runs in the <100> direction, which is parallel to the plane of the substrate, but also one in which it runs in a direction equivalent to that direction (e.g., the <001> direction, which is perpendicular to the plane of the substrate). Seeing that the film's degree of (100) orientation was 90%, the remaining 10% is considered to have been (111) orientation.

The sectional shape of the deposited PNZT film was inspected on a scanning electron microscope (SEM), and it was found that a columnar crystal with a film thickness of 4 $\mu$m was obtained. When the crystal structure of the deposited PNZT film is columnar, the film has a single crystal grain in the thickness direction, and the crystal grain has a larger volume than a particulate crystal. Thus, a larger number of polarization domains are present in the single crystal, and an improved piezoelectric property due to polarization rotation is expected.

The composition of the PNZT film was analyzed by energy dispersion X-ray spectroscopy (EDX), and it was found that the Zr/Ti ratio was 56.8/43.2 by mol ratio (with a Zr composition ratio of 56.8% by mol), that the Nb composition ratio (addition ratio) was 10.5% by mol, and thus that a film with a composition close to that of the target was obtained. Incidentally, the Pb composition ratio of the film was 104.1% by mol. The warp of the wafer before and after film deposition was measured on a contact step gauge to determine the film stress. The film stress can be calculated from the warp of the wafer before and after film deposition according to the formula below.

[Formula 1]

$$\sigma = \frac{1}{3d}\frac{Es}{1-vs}D^2\frac{h_2-h_1}{a^2}$$

Here, d represents the film thickness, D represents the wafer thickness, Es represents the longitudinal elastic coefficient of the wafer, vs represents the Poisson ratio of the wafer, a represents the radius of the substrate, $h_2$ represents the warp of the wafer after film deposition, and $h_1$ represents the warp of the wafer before film deposition. With the Si substrate Es was 160 [GPa] and vs was 0.2. The measurement found that the film stress of the PNZT was 150 MPa.

When the composition of the PNZT is expressed by $Pb_{1+\delta}[(Zr_xTi_{1-x})_{1-y}Nb_y]O_3$, the Zr composition ratio corresponds to the value of x, the Nb composition ratio corresponds to the value of y, and the Pb composition ratio corresponds to the value of $(1+\delta)$.

Next, on the piezoelectric thin film 44, Au was vapor-deposited to form an upper electrode so that a piezoelectric element 50 (see Fig. 8) is complete, then the piezoelectric element 50 was cut out of the wafer into the shape of a strip, and the piezoelectric constant $d_{31}$ was determined by a cantilever method using a piezoelectric displacement tester as shown in Fig. 8. The result was that $d_{31}$ = -235.6 pm/V, and it was thus found that a piezoelectric property higher than the target value, -200 pm/V, was obtained.

On the piezoelectric displacement tester mentioned above, an end part of the piezoelectric element 50 was clamped by a clamp 51 to form a cantilever structure such that the movable length of the cantilever was 10 mm, a voltage was applied from a function generator 52 at a frequency of 500 Hz such that the upper electrode had a maximum of 0 V and the lower electrode had a minimum of -20 V, and the displacement of the end part of the piezoelectric element 50 was observed with a laser Doppler oscillometer 53. Then, from the observed piezoelectric displacement, the piezoelectric constant $d_{31}$ was determined by a known method.

Next, With a semiconductor parameter analyzer B1500A manufactured by Agilent, the I-V withstand voltage was evaluated. The result was that the withstand voltage was 72 V, and thus a withstand voltage exceeding the target value, 70 V, was obtained.

(Practical Example 2)

On a Pt/Ti/Si substrate fabricated in a similar manner as in Practical Example 1, by use of a sputtering machine, PLT was deposited with a thickness of about 100 nm as a seed layer 45 as shown in Fig. 7. The seed layer 45 corresponds to the seed layer 29 in Fig. 5. PLT was sputtered under the following conditions: Ar flow rate, 30 sccm; $O_2$ flow rate, 0.6 sccm; pressure, 0.5 Pa; substrate temperature, 700 °C; RF power applied to the target, 300 W.

Subsequently, on the sputtering machine, on the PLT, a film of PNZT was deposited with a thickness of about 3 $\mu$m to form a piezoelectric thin film 44. PNZT was sputtered under the following conditions: Ar flow rate, 20 sccm; $O_2$ flow rate, 0.5 sccm; pressure, 0.4 Pa; substrate temperature, 550 °C; RF power applied to the target, 600 W. Used as the target for sputtering was one with a Zr/Ti ratio of 54/46 by mol ratio, having 12% by mol of Nb added to it.

The deposited PNZT film was inspected by X-ray diffraction (XRD), and it was found that the PNZT film had multiple orientations. The composition of the PNZT film was analyzed by EDX, and it was found that the Zr/Ti ratio was 54.1/45.9 by mol ratio, that the Nb composition ratio was 12.1% by mol, and thus that a film with a composition close to that of the target was obtained. Incidentally, the Pb composition ratio of the film was 102.5% by mol. The warp of the wafer before and after film deposition was measured to determine the film stress, and the result was that the film stress of the PNZT was 100 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -250.3 pm/V, and it was thus found that a piezoelectric property higher than the target value, -200 pm/V, was obtained.

Moreover, when, in a similar manner as in Practical Example 1, the I-V withstand voltage was evaluated, the withstand voltage was 80 V, and thus a withstand voltage exceeding the target value, 70 V, was obtained.

(Practical Example 3)

On a PLT/Pt/Ti/Si substrate fabricated in a similar manner as in Practical Example 2, by use of a sputtering machine, a film of PNZT was deposited with a thickness of about 6 $\mu$m to form a piezoelectric thin film 44. PNZT was sputtered under the following conditions: Ar flow rate, 20 sccm; $O_2$ flow rate, 0.5 sccm; pressure, 0.4 Pa; substrate temperature, 650 °C; RF power applied to the target, 600 W. Used as the target for sputtering was one with a Zr/Ti ratio of 54/46 by mol ratio, having 15% by mol of Nb added to it.

The deposited PNZT film was inspected by XRD, and the result was that the film's degree of (100) orientation was 99%. The sectional shape of the deposited PNZT film was inspected on a SEM, and it was found that a columnar crystal with a film thickness of 6 $\mu$m was obtained. The composition of the PNZT film was analyzed by EDX, and it was found that the Zr/Ti ratio was 55.4/44.6 by mol ratio, that the Nb composition ratio was 15.4% by mol, and thus that a film with a composition close to that of the target was obtained. Incidentally, the Pb composition ratio of the film was 104.4% by mol. The warp of the wafer before and after film deposition was measured to determine the film stress, and the result was that the film stress of the PNZT was 250 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -280.2 pm/V, and it was thus found that a piezoelectric property higher than the target value, -200 pm/V, was obtained.

Moreover, when, in a similar manner as in Practical Example 1, the I-V withstand voltage was evaluated, the withstand voltage was 72 V, and thus a withstand voltage exceeding the target value, 70 V, was obtained.

(Practical Example 4)

On a PLT/Pt/Ti/Si substrate fabricated in a similar manner as in Practical Example 2, by use of a sputtering machine, a film of PNZT was deposited with a thickness of about 5 $\mu$m to form a piezoelectric thin film 44. PNZT was sputtered under the same conditions as in Practical Example 3. Used as the target for sputtering was one with a Zr/Ti ratio of 58/42 by mol ratio, having 18% by mol of Nb added to it.

The deposited PNZT film was inspected by XRD, and the result was that the film's degree of (100) orientation was 98%. The sectional shape of the deposited PNZT film was inspected on a SEM, and it was found that a columnar crystal with a film thickness of 5 $\mu$m was obtained. The composition of the PNZT film was analyzed by EDX, and it was found that the Zr/Ti ratio was 58.9/41.1 by mol ratio, that the Nb composition ratio was 18.2% by mol, and thus that a film with a composition close to that of the target was obtained. Incidentally, the Pb composition ratio of the film was 105.0% by mol. The warp of the wafer before and after film deposition was measured to determine the film stress, and the result was that the film stress of the PNZT was 200 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -269.9 pm/V, and it was thus found that a piezoelectric property higher than the target value, -200 pm/V, was obtained.

Moreover, when, in a similar manner as in Practical Example 1, the I-V withstand voltage was evaluated, the withstand voltage was 80 V, and thus a withstand voltage exceeding the target value, 70 V, was obtained.

(Practical Example 5)

On a PLT/Pt/Ti/Si substrate fabricated in a similar manner as in Practical Example 2, by use of a sputtering machine, a film of PNZT was deposited with a thickness of about 3 $\mu$m to form a piezoelectric thin film 44. PNZT was sputtered under the same conditions as in Practical Example 3. Used as the target for sputtering was one with a Zr/Ti ratio of 58/42 by mol ratio, having 20% by mol of Nb added to it.

The deposited PNZT film was inspected by XRD, and the result was that the film's degree of (100) orientation was 98%. The sectional shape of the deposited PNZT film was inspected on a SEM, and it was found that a columnar crystal with a film thickness of 3 $\mu$m was obtained. The composition of the PNZT film was analyzed by EDX, and it was found that the Zr/Ti ratio was 57.8/42.2 by mol ratio, that the Nb composition ratio was 20.0% by mol, and thus that a film with a composition close to that of the target was obtained. Incidentally, the Pb composition ratio of the film was 101.9% by mol. The warp of the wafer before and after film deposition was measured to determine the film stress, and the result was that the film stress of the PNZT was 150 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -203.0 pm/V, and it was thus found that a piezoelectric property higher than the target value, -200 pm/V, was obtained.

Moreover, when, in a similar manner as in Practical Example 1, the I-V withstand voltage was evaluated, the withstand voltage was 85 V, and thus a withstand voltage exceeding the target value, 70 V, was obtained.

(Practical Example 6)

On a Pt/Ti/Si substrate fabricated in a similar manner as in Practical Example 1, by use of a sputtering machine, a film of PNZT was deposited with a thickness of about 4 $\mu$m to form a piezoelectric thin film 44. PNZT was sputtered under the following conditions: Ar flow rate, 20 sccm; $O_2$ flow rate, 0.6 sccm; pressure, 0.5 Pa; substrate temperature, 650 °C; RF power applied to the target, 500 W. Used as the target for sputtering was one with a Zr/Ti ratio of 52/48 by mol ratio, having 10% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 4 $\mu$m was obtained. The composition of the PNZT film was analyzed by EDX, and it was found that the Zr/Ti ratio was 52.5/47.5 by mol ratio, that the Nb composition ratio was 10.1% by mol, and thus that a film with a composition close to that of the target was obtained. Incidentally, the Pb composition ratio of the film was 103.0% by mol. The warp of the wafer before and after film deposition was measured to determine the film stress, and the result was that the film stress of the PNZT was 180 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -214.6 pm/V, and it was thus found that a piezoelectric property higher than the target value, -200 pm/V, was obtained.

Moreover, when, in a similar manner as in Practical Example 1, the I-V withstand voltage was evaluated, the withstand voltage was 71 V, and thus a withstand voltage exceeding the target value, 70 V, was obtained.

(Comparative Example 1)

On a Pt/Ti/Si substrate fabricated in a similar manner as in Practical Example 1, by use of a sputtering machine, a film of PNZT was deposited with a thickness of about 4 $\mu$m to form a piezoelectric thin film 44. PNZT was sputtered under the following conditions: Ar flow rate, 20 sccm; $O_2$ flow rate, 0.6 sccm; pressure, 0.5 Pa; substrate temperature, 500 °C; RF power applied to the target, 500 W. Used as the target for sputtering was one with a Zr/Ti ratio of 52/48 by mol ratio, having 10% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 4 $\mu$m was obtained. The composition of the PNZT film was analyzed by EDX, and it was found that the Zr/Ti ratio was 52.1/47.9 by mol ratio, that the Nb composition ratio was 9.5% by mol, and thus that a film with a composition close to that of the target was obtained. Incidentally, the Pb composition ratio of the film was 103.6% by mol. The warp of the wafer before and after film deposition was measured to determine the film stress, and the result was that the film stress of the PNZT was 90 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -178.7 pm/V, which did not reach the target value, -200 pm/V.

Moreover, when, in a similar manner as in Practical Example 1, the I-V withstand voltage was evaluated, the withstand voltage was 62 V, which was under the target value, 70 V.

(Comparative Example 2)

On a Pt/Ti/Si substrate fabricated in a similar manner as in Practical Example 1, by use of a sputtering machine, PNZT was deposited with a thickness of about 6 $\mu$m to form a piezoelectric thin film 44. a film of PNZT was sputtered under the same conditions as in Practical Example 1. Used as the target for sputtering was one with a Zr/Ti ratio of 60/40 by mol ratio, having 22% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 6 $\mu$m was obtained. The composition of the PNZT film was analyzed by EDX, and it was found that the Zr/Ti ratio was 60.1/39.9 by mol ratio, that the Nb composition ratio was 21.5% by mol, and thus that a film with a composition close to that of the target was obtained. Incidentally, the Pb composition ratio of the film was 106.1% by mol. The warp of the wafer before and after film deposition was measured to determine the film stress, and the result was that the film stress of the PNZT was 260 MPa. Because of such high stress, a crack was observed in part of the film.

Next, in a similar manner as in Practical Example 1, an upper electrode was formed on the piezoelectric thin film 44, in a region where no crack was observed, to complete a piezoelectric element 50, the piezoelectric element 50 was cut out of the wafer into the shape of a strip, and the piezoelectric constant $d_{31}$ was determined by a cantilever method. The result was that $d_{31}$ = -190.2 pm/V, which did not reach the target value, -200 pm/V.

Moreover, in a similar manner as in Practical Example 1, the I-V withstand voltage was evaluated. The withstand voltage was 58 V, which was under the target value, 70 V.

(Comparative Example 3)

On a Pt/Ti/Si substrate fabricated in a similar manner as in Practical Example 1, by use of a sputtering machine, a film of PZT was deposited with a thickness of about 4 $\mu$m to form a piezoelectric thin film 44. PZT was sputtered under the same conditions under which PNZT was sputtered in Practical Example 1. Used as the target for sputtering was one with a Zr/Ti ratio of 52/48 by mol ratio.

The deposited PZT film was inspected by XRD, and the result was that the film's degree of (100) orientation was 90%. The sectional shape of the deposited PZT film was inspected on a SEM, and it was found that a columnar crystal with a film thickness of 4 $\mu$m was obtained. The composition of the PZT film was analyzed by EDX, and it was found that the Zr/Ti ratio was 52.2/47.8 by mol ratio, and thus that a film with a composition close to that of the target was obtained. Incidentally, the Pb composition ratio of the film was 104.1% by mol. The warp of the wafer before and after film deposition was measured to determine the film stress, and the result was that the film stress of the PZT was 90 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -166.0 pm/V, which did not reach the target value, -200 pm/V, which was attained with PNZT.

Moreover, when, in a similar manner as in Practical Example 1, the I-V withstand voltage was evaluated, the withstand voltage was 56 V, which was under the target value, 70 V.


(Comparative Example 4)

On a Pt/Ti/Si substrate fabricated in a similar manner as in Practical Example 1, by use of a sputtering machine, a film of PZT was deposited with a thickness of about 4 $\mu$m to form a piezoelectric thin film 44. PZT was sputtered under the same conditions under which PNZT was sputtered in Practical Example 1. Used as the target for sputtering was one with a Zr/Ti ratio of 55/45 by mol ratio.

The deposited PZT film was inspected by XRD, and the result was that the film's degree of (100) orientation was 90%. The sectional shape of the deposited PZT film was inspected on a SEM, and it was found that a columnar crystal with a film thickness of 4 $\mu$m was obtained. The composition of the PZT film was analyzed by EDX, and it was found that the Zr/Ti ratio was 54.5/45.5 by mol ratio, and thus that a film with a composition close to that of the target was obtained. Incidentally, the Pb composition ratio of the film was 103.9% by mol. The warp of the wafer before and after film deposition was measured to determine the film stress, and the result was that the film stress of the PZT was 110 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -144.3 pm/V, which did not reach the target value, -200 pm/V, which was attained with PNZT.

Moreover, when, in a similar manner as in Practical Example 1, the I-V withstand voltage was evaluated, the withstand voltage was 75 V, and thus a withstand voltage exceeding the target value, 70 V, was obtained.


(Comparative Example 5)

On a Pt/Ti/Si substrate fabricated in a similar manner as in Practical Example 1, by use of a sputtering machine, a film of PZT was deposited with a thickness of about 4 $\mu$m to form a piezoelectric thin film 44. PZT was sputtered under the same conditions under which PNZT was sputtered in Practical Example 1. Used as the target for sputtering was one with a Zr/Ti ratio of 60/40 by mol ratio.

The deposited PZT film was inspected by XRD, and the result was that the film's degree of (100) orientation was 90%. The sectional shape of the deposited PZT film was inspected on a SEM, and it was found that a columnar crystal with a film thickness of 4 $\mu$m was obtained. The composition of the PZT film was analyzed by EDX, and it was found that the Zr/Ti ratio was 60.3/39.7 by mol ratio, and thus that a film with a composition close to that of the target was obtained. Incidentally, the Pb composition ratio of the film was 103.6% by mol. The warp of the wafer before and after film deposition was measured to determine the film stress, and the result was that the film stress of the PZT was 100 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -137.1 pm/V, which did not reach the target value, -200 pm/V, which was attained with PNZT.

Moreover, when, in a similar manner as in Practical Example 1, the I-V withstand voltage was evaluated, the withstand voltage was 78 V, and thus a withstand voltage exceeding the target value, 70 V, was obtained.


(Comparative Example 6)

On a Pt/Ti/Si substrate fabricated in a similar manner as in Practical Example 1, by use of a sputtering machine, a film of PNZT was deposited with a thickness of about 4 $\mu$m to form a piezoelectric thin film 44. PNZT was sputtered under the same conditions as in Practical Example 2. Used as the target for sputtering was one with a Zr/Ti ratio of 52/48 by mol ratio, having 12% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 4 $\mu$m was obtained. The composition of the PNZT film was analyzed by EDX, and it was found that the Zr/Ti ratio was 51.9/48.1 by mol ratio, that the Nb composition ratio was 12.4% by mol, and thus that a film with a composition close to that of the target was obtained. Incidentally, the Pb composition ratio of the film was 103.8% by mol. The warp of the wafer before and after film deposition was measured to determine the film stress, and the result was that the film stress of the PNZT was 120 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -249.5 pm/V, and thus it was found that a piezoelectric property higher than the target value, -200 pm/V, was obtained.

However, when, in a similar manner as in Practical Example 1, the I-V withstand voltage was evaluated, the withstand voltage was 55 V, which was under the target value, 70 V.

(Comparative Example 7)

On a Pt/Ti/Si substrate fabricated in a similar manner as in Practical Example 1, by use of a sputtering machine, a film of PNZT was deposited with a thickness of about 4 $\mu$m to form a piezoelectric thin film 44. PNZT was sputtered under the following conditions: Ar flow rate, 20 sccm; O$_2$ flow rate, 0.8 sccm; pressure, 0.5 Pa; substrate temperature, 450 °C; RF power applied to the target, 500 W. Used as the target for sputtering was one with a Zr/Ti ratio of 52/48 by mol ratio, having 10% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 4 $\mu$m was obtained. The composition of the PNZT film was analyzed by EDX, and it was found that the Zr/Ti ratio was 52.2/47.8 by mol ratio, that the Nb composition ratio was 10.6% by mol, and thus that a film with a composition close to that of the target was obtained. Incidentally, the Pb composition ratio of the film was 111.0% by mol. The warp of the wafer before and after film deposition was measured to determine the film stress, and the result was that the film stress of the PNZT was 80 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -186.4 pm/V, which was under the target value, -200 pm/V.

Moreover, when, in a similar manner as in Practical Example 1, the I-V withstand voltage was evaluated, the withstand voltage was 45 V, which was under the target value, 70 V.

(Comparative Example 8)

On a Pt/Ti/Si substrate fabricated in a similar manner as in Practical Example 1, by use of a sputtering machine, a film of PNZT was deposited with a thickness of about 4 $\mu$m to form a piezoelectric thin film 44. PNZT was sputtered under the following conditions: Ar flow rate, 20 sccm; O$_2$ flow rate, 0.3 sccm; pressure, 0.5 Pa; substrate temperature, 700 °C; RF power applied to the target, 500 W. Used as the target for sputtering was one with a Zr/Ti ratio of 55/45 by mol ratio, having 15% by mol of Nb added to it.

The deposited PNZT film was inspected by XRD, and the result was that the film's degree of (100) orientation was 90%. The sectional shape of the deposited PNZT film was inspected on a SEM, and it was found that a columnar crystal with a film thickness of 4 $\mu$m was obtained. The composition of the PNZT film was analyzed by EDX, and it was found that the Zr/Ti ratio was 55.2/44.8 by mol ratio, that the Nb composition ratio was 15.5% by mol, and thus that a film with a composition close to that of the target was obtained. Incidentally, the Pb composition ratio of the film was 97.8% by mol. The warp of the wafer before and after film deposition was measured to determine the film stress, and the result was that the film stress of the PNZT was 210 MPa.

Next, in a similar manner as in Practical Example 1, an upper electrode was formed on the piezoelectric thin film 44 to complete a piezoelectric element 50, the piezoelectric element 50 was cut out of the wafer into the shape of a strip, and the piezoelectric constant $d_{31}$ was determined by a cantilever method. The result was that $d_{31}$ = -137.5 pm/V, which did not reach the target value, -200 pm/V.

Moreover, when, in a similar manner as in Practical Example 1, the I-V withstand voltage was evaluated, the withstand voltage was 90 V, and thus a withstand voltage exceeding the target value, 70 V, was obtained.

Table 1 shows a summary of the results of measurement with Practical Examples 1 to 6 and Comparative Examples 1 to 8. Table 1 also shows the target values of their respective compositions and parameters, and the results of evaluation of the films. The films are evaluated according to the following criteria:

(Evaluation Criteria)

"Poor" indicates that the piezoelectric property is lower than the target value.

"Fair" indicates that the piezoelectric property is equal to or higher than the target value but the withstand voltage is lower than the target value..

"Good" indicates that both the piezoelectric property and the withstand voltage are equal to or higher than the target values.

"Excellent" indicates that both the piezoelectric property and the withstand voltage are equal to or higher than the target values, the piezoelectric properties being especially high ($|d_{31}| \geq 260$ V).

[Table 1]

| | Nb [mol%] | Pb [mol%] | Zr [mol%] | Ti [mol%] | Stress [MPa] | Piezoelectric Property $d_{31}$[-pm/V] | Withstand Voltage [V] | Evaluation |
|---|---|---|---|---|---|---|---|---|
| Target Value | 10 to 20 | 100 or more | 52 to 59 | 48 to 41 | 100 to 250 | 200 or more | 70 or more | - |
| Practical Example 1 | 10.5 | 104.1 | 56.8 | 43.2 | 150 | 235.6 | 72 | Good |
| Practical Example 2 | 12.1 | 102.5 | 54.1 | 45.9 | 100 | 250.3 | 80 | Good |
| Practical Example 3 | 15.4 | 104.4 | 55.4 | 44.6 | 250 | 280.2 | 72 | Excellent |
| Practical Example 4 | 18.2 | 105.0 | 58.9 | 41.1 | 200 | 269.9 | 80 | Excellent |
| Practical Example 5 | 20.0 | 101.9 | 57.8 | 42.2 | 150 | 203.0 | 85 | Good |
| Practical Example 6 | 10.1 | 103.0 | 52.5 | 47.5 | 180 | 214.6 | 71 | Good |
| Comparative Example 1 | 9.5 | 103.6 | 52.1 | 47.9 | 90 | 178.7 | 62 | Poor |
| Comparative Example 2 | 21.5 | 106.1 | 60.1 | 39.9 | 260 | 190.2 | 58 | Poor |
| Comparative Example 3 | 0.0 | 104.1 | 52.2 | 47.8 | 90 | 166.0 | 56 | Poor |
| Comparative Example 4 | 0.0 | 103.9 | 54.5 | 45.5 | 110 | 144.3 | 75 | Poor |
| Comparative Example 5 | 0.0 | 103.6 | 60.3 | 39.7 | 100 | 137.1 | 78 | Poor |
| Comparative Example 6 | 12.4 | 103.8 | 51.9 | 48.1 | 120 | 249.5 | 55 | Fair |
| Comparative Example 7 | 10.6 | 111.0 | 52.2 | 47.8 | 80 | 186.4 | 45 | Poor |
| Comparative Example 8 | 15.5 | 97.8 | 55.2 | 44.8 | 210 | 137.5 | 90 | Poor |

Table 1 reveals the following. With the films (PNZT or PZT films) of Comparative Examples 1 to 8, at least one of the Nb, Pb, Zr, and Ti composition ratios and the film stress falls outside the target value ranges, with the result that at least one of the piezoelectric property and the withstand voltage is lower than the target value. In contrast, with the PNZT films of Practical Examples 1 to 6, the Nb, Pb, Zr, and Ti composition ratios and the film stress all fall in the target value ranges, with the result that the piezoelectric property and the withstand voltage are both equal to or higher than the target values.

Accordingly, with a PNZT film, by properly adjusting the Nb, Pb, Zr, and Ti composition ratios and the film stress so that these fall in the target value ranges, it is possible to achieve a high piezoelectric property ($|d_{31}| \geq 200$ V) with a composition unique to a PNZT thin film, and it is possible also to improve the withstand voltage, and hence the durability, of the PNZT film.

That is, it can be said that, with a PNZT film, simultaneously fulfilling conditions (1a) to (1d) out of conditions (1) below leads to a high piezoelectric property with $d_{31}$ exceeding -200 pm/V combined with a withstand voltage exceeding 70 V. Incidentally, Practical Examples 1 to 6 fulfill conditions (1).

<Conditions (1)>

(1a) The Pb composition ratio (the ratio "a" of Pb to the sum of Zr, Ti, and Nb) is equal to or higher than 100% by mol ratio.
(1b) The Nb composition ratio (the ratio "b" of Nb to the sum of Zr, Ti, and Nb) is 10% or more but 20% or less by mol ratio.
(1c) The Zr composition ratio (the ratio "c" of Zr to the sum of Zr and Ti) is 52% or more but 59% or less by mol ratio.
(1d) The film stress is 100 MPa or more but 250 MPa or less.

Here, if the film stress of a PNZT film is lower than 100 MPa, the optimum composition is close to that in the case of bulk, where no stress is applied, and this makes it difficult to obtain a high piezoelectric property with a composition unique to a thin film. On the other hand, if the film stress is higher than 250 MPa, the film may develop a crack, or the film may prone to exfoliate when the film is formed on the substrate, making it difficult to obtain a high piezoelectric property. Accordingly, under conditions (1), by controlling the film stress in the range of 100 MPa or more but 250 MPa or less, it is possible, with the composition unique to the thin film mentioned above (the ratios "a" to "c"), to achieve a high piezoelectric property without developing a crack or the like.

While the higher the film stress, the better, if it exceeds 190 MPa, the piezoelectric property is so high that, when the film is formed on the substrate, it is prone to exfoliate, and therefore it is then preferable to reinforce the film to prevent exfoliation by a known method.

In conditions (1), the upper limit of the Pb composition ratio is not defined; this means that, under the condition that the film stress is 100 MPa or more but 250 MPa or less, the Pb composition ratio can be increased. In reality, increasing the Pb composition ratio results in increasing the film stress; thus, to control the film stress so that it is equal to or lower than 250 MPa, it is preferable that the Pb composition ratio be 105% by mol or less.

On the other hand, from the results with Practical Examples 1 to 5 shown in Table 1, it can be said that, with a PNZT film, simultaneously fulfilling conditions (2a) to (2c) out of conditions (2) below leads to a high piezoelectric property with a $d_{31}$ exceeding -200 pm/V combined with a withstand voltage exceeding 70 V.

<Conditions (2)>

(2a) The Pb composition ratio (the ratio "a" of Pb to the sum of Zr, Ti, and Nb) is 100% or more but 105% or less by mol ratio.
(2b) The Nb composition ratio (the ratio "b" of Nb to the sum of Zr, Ti, and Nb) is 10% or more but 20% or less by mol ratio.
(2c) The Zr composition ratio (the ratio "c" of Zr to the sum of Zr and Ti) is 54% or more but 59% or less by mol ratio.

In particular, it can be said that, by controlling the Zr composition ratio in the rage of 54% or more but 59% or less by mol ratio, that is, by adopting a condition stricter than conditions (1), it is possible to reliably improve the withstand voltage of the PNZT film so that it is equal to or higher than 72 V and thereby reliably improve its durability.

In Practical Examples 3 and 4, $|d_{31}|$ was 260 pm/V, which was a value still higher than the target value. Based on these results, it can be said that, with a Nb composition ratio (ratio "b") of 15% or more but 19% or less by mol ratio and a Zr composition ratio (ratio "c") of 55% or more but 59% or less by mol ratio, it is possible to achieve a still higher piezoelectric property. In particular, based on Table 1, it can be said that, with a Pb composition ratio ("a") of 104% or more but 105% or less, that effect can be obtained reliably.

In Practical Examples 1 and 3 to 6, the degree of (100) orientation of the PNZT film was 90% or more, and thus it can be said that the crystal orientation (main orientation) is a (100) orientation. With a (100) orientation, the polarization rotation of domains (e.g., the change of the polarization direction from the <100> direction, which is parallel to the plane of the substrate, to the <001> direction, which is perpendicular to the plane of the substrate) can be exploited to improve the piezoelectric property. It is thus possible to achieve a higher piezoelectric property than with a (111) orientation, in which no such rotation of domains occurs.

In a piezoelectric thin film-coated substrate 40 having a piezoelectric thin film 44 formed as an upper layer relative to a substrate 41, it is considered that the difference in thermal expansion coefficient between the piezoelectric thin film 44 and the substrate 41, which are heterogeneous materials, applies a high film stress (thermal stress) as mentioned above to the piezoelectric thin film 44. This makes it possible to obtain a piezoelectric property with $d_{31}$ exceeding -200 pm/V.

In particular, because Si has a thermal expansion coefficient of 2.6 ppm/K and PNZT has a thermal expansion coefficient of about 8 ppm/K, when the substrate 41 is formed of Si and the piezoelectric thin film 44 is formed of PNZT, it is considered that the piezoelectric thin film 44 is sure to be given a high film stress during film deposition at high temperature due to the difference in thermal expansion coefficient from the substrate 41. In this way, it is possible to achieve a high piezoelectric property in the piezoelectric thin film 44. Incidentally, so long as it contains Si, the substrate 41 may be a substrate of silicon alone, or an SOI substrate as mentioned earlier.

Where, as in Practical Examples 2 to 5, the seed layer 45 is formed between the substrate 41 and the piezoelectric thin film 44, it is possible, by using the seed layer 45 as an underlayer, to form on top of it a piezoelectric thin film 44 with high crystallinity. It is considered that, in that way, it is possible to easily achieve a piezoelectric property with $d_{31}$ exceeding -200 pm/V.

In particular, because the seed layer is formed of PLT having a perovskite structure, it is considered that it is easy to form the piezoelectric thin film 44 as a single-phase perovskite on top of the PLT and thereby to more easily achieve a high piezoelectric property.

Moreover, because an electrode (lower electrode 43) is formed between the substrate 41 and the piezoelectric thin film 44, it is possible to obtain a piezoelectric thin film-coated substrate 40 that is suitable for a piezoelectric actuator (piezoelectric element 50) composed of a piezoelectric thin film 44 held between a pair of electrodes (the lower electrode 43 and an upper electrode).

Next, the results of examining the relationship between the film thickness and the piezoelectric property of PNZT thin films will be presented.

(Practical Examples 7 to 9 and Comparative Examples 9 to 10)

Films of PNZT were deposited by a method similar to that used in Practical Example 2. Here, the duration for which PNZT films were deposited was varied so that they were deposited with varying film thicknesses of 3.0 to 13.2 μm. Then, the piezoelectric property of the PNZT with different film thicknesses was evaluated. Table 2 shows, for the PNZT with each different film thickness, the results of measurement, performed as with Practical Example 1, etc., of the film stress and the piezoelectric property. As for Comparative Example 10, because the film developed a crack ascribable to a high stress, no measurement of the piezoelectric property was performed.

[Table 2]

|  | PNZT Thickness[μm] | Stress[Mpa] | Piezoelectric Property $d_{31}$[-pm/V] |
|---|---|---|---|
| Practical Example 2 | 3.0 | 100 | 250.3 |
| Practical Example 7 | 4.0 | 150 | 251.6 |
| Practical Example 8 | 6.2 | 220 | 255.2 |
| Practical Example 9 | 10.0 | 250 | 214.8 |
| Comparative Example 9 | 11.2 | 260 | 163.0 |
| Comparative Example 10 | 13.2 | 300 | - |

Table 2 reveals the following. With PNZT films with a film thickness of 10 μm or less, a high piezoelectric with $d_{31}$ exceeding -200 pm/V was obtained (cf. Practical Examples 2 and 7 to 9). On the other hand, with PNZT films with a thickness exceeding 10 μm as in Comparative Examples 9 and 10, $d_{31}$ did not reach -200 pm/V, and hence the film developed a crack. It can thus be said that it is preferable that a PNZT film have a film thickness of 10 μm or less. It has been found that, with a PNZT film with a thickness less than 1 μm, it is difficult to obtain the desired displacement generating power with a thin film, and it is difficult to apply it to devices such as piezoelectric actuators. Accordingly, with consideration given to application to devices and the piezoelectric property, it can be said that it is preferable that a PNZT film have a thickness in the range of 1 to 10 μm.

[Other]

In the practical examples described above, sputtering is used to form a piezoelectric thin film (ferroelectric thin film), but this is not meant to limit the method for producing the film. So long as such PNZT composition ratios as presented in those practical examples can be obtained, it is possible to deposit the piezoelectric thin film by using, for example, a physical film deposition process such as a pulse laser deposition process or an ion-plating process, a sol-gel process, or a chemical film deposition process such as a metal organic chemical vapor deposition process.

A ferroelectric thin film, a piezoelectric thin film-coated substrate, a piezoelectric actuator, an inkjet head, and an inkjet printer according to the present invention as described above can be expressed as noted below, and offer effects and benefits as noted below.

According to one aspect of the present invention, a ferroelectric thin film is composed of lead niobate titanate zirconate. Here, the ratio "a" of lead to the sum of zirconium, titanium, and niobium is 100% or more by mol ratio, the ratio "b" of niobium to the sum of zirconium, titanium, and niobium is 10% or more but 20% or less by mol ratio, the ratio "c" of zirconium to the sum of zirconium and titanium is 52% or more but 59% or less by mol ratio, and the film stress is 100 MPa or more but 250 MPa or less.

By defining the ratios (ratios "a" to "c") of the Pb, Nb, and Zr contained in PNZT in the above-mentioned ranges which differ from the optimum ranges in bulk, it is possible to achieve, with a thin film of PNZT, a high piezoelectric (e.g., with $|d_{31}| \geq 200$ pm/V) that could not be achieved with a thin film of PZT. Moreover, by defining the film stress in the above-mentioned range, it is possible, with the above-mentioned compositions (ratios "a" to "c"), to achieve a high piezoelectric property without developing a crack or the like. Furthermore, by defining the ranges of the Pb and Nb ratios as mentioned above and in addition defining the Zr ratio in the above-mentioned range, it is possible to improve the withstand voltage of the PNZT film, and to improve its durability. Incidentally, controlling the Zr ratio (ratio "c") in the range of more than 52% but less than 59% by mol ratio is preferable from the viewpoints of reliably improving the withstand voltage of the PNZT film and reliably improving its durability.

The ratio "a" may be 105% or less by mol ratio. In this case, it is possible, in the above-mentioned ranges of the ratios "b" and "c", to reliably achieve the film stress in the above-mentioned range.

According to another aspect of the present invention, a ferroelectric thin film is formed of lead niobate titanate zirconate. Here, the ratio "a" of lead to the sum of zirconium, titanium, and niobium is 100% or more but 105% or less by mol ratio, the ratio "b" of niobium to the sum of zirconium, titanium, and niobium is 10% or more but 20% or less by mol ratio, and the ratio "c" of zirconium to the sum of zirconium and titanium is 54% or more but 59% or less by mol ratio.

By defining the ratios (ratios "a" to "c") of the Pb, Nb, and Zr contained in PNZT in the above-mentioned ranges which differ from the optimum ranges in bulk, it is possible to achieve, with a thin film of PNZT, a high piezoelectric (e.g., with $|d_{31}| \geq 200$ pm/V) that could not be achieved with a thin film of PZT. Moreover, by restricting, when the ratios "a" and "b" are in the above-mentioned ranges, the ratio "c" to the above-mentioned range, it is possible to reliably improve the withstand voltage of the PNZT film, and to reliably improve its durability.

It is preferable that the ratio "b" be 15% or more but 19% or less by mol ratio, and that the ratio "c" be 55% or more but 59% or less. In this case, it is possible, with a thin film of PNZT, to achieve a still higher piezoelectric property (e.g., with $|d_{31}| \geq 260$ pm/V).

In the above ferroelectric thin film, it is preferable that the crystal orientation of the film is a (100) orientation of a pseudo-cubic crystal. In this case, non-180° polarization rotation of domains occurs at a lower electric field than in other crystal structures, and this can be exploited to improve the piezoelectric property. In this way, it is possible to achieve a high piezoelectric property compared with where the crystal orientation of the film is a (111) orientation.

In the above ferroelectric thin film, it is preferable that the crystal structure of the film is a columnar crystal. In this case, compared with where the crystal structure of the film is a particulate crystal, a larger number of polarization domains are present in a single crystal, and an improved piezoelectric property due to polarization rotation is expected.

In the above ferroelectric thin film, it is preferable that the film thickness be 1 $\mu$m or more but 10 $\mu$m or less. When the film thickness of the PNZT film is less than 1 $\mu$m, it is difficult to obtain the desired displacement generating power with a thin film, and this makes application to devices such as piezoelectric actuators difficult. On the other hand, with a film thickness exceeding 10 $\mu$m, the film is prone to develop a crack, and it is difficult to obtain a high piezoelectric property. Accordingly, with the film thickness of the PNZT film defined in the above-mentioned range, it is possible to obtain the desired displacement generating force with a thin film and thereby make application to devices easy, and to obtain a high piezoelectric property.

According to yet another aspect of the present invention, a piezoelectric thin film-coated substrate has a piezoelectric thin film formed as an upper layer relative to a substrate, and here, the piezoelectric thin film is formed out of a ferroelectric thin film as described above. In this case, because of the difference in thermal expansion coefficient from the substrate, it is possible to give the piezoelectric thin film (ferroelectric thin film) a high film stress and obtain a high piezoelectric property.

It is preferable that the substrate is formed out of a silicon substrate or an SOI substrate. A SOI substrate is a substrate composed of two silicon substrates bonded together via an oxide film. The Si of the substrate differs from PNZT in thermal expansion coefficient; thus, it is possible to reliably give the piezoelectric thin film formed of PNZT a high film stress, and to reliably achieve a high piezoelectric property.

It is preferable that a seed layer for controlling the crystal orientation of the piezoelectric thin film be disposed between the substrate and the piezoelectric thin film. In this case, it is possible to form a piezoelectric thin film with high crystallinity on the seed layer, and to achieve a high piezoelectric property easily.

It is preferable that the seed layer be formed of lead lanthanum titanate. PLT has a perovskite structure; this makes it easy to form the piezoelectric thin film as a single-phase perovskite on the PLT, and makes it still easier to achieve a high piezoelectric property.

It is preferable that an electrode be formed between the substrate and the piezoelectric thin film. In this case, it is possible to obtain a piezoelectric thin film-coated substrate that is suitable for an piezoelectric actuator composed of a piezoelectric thin film held between a pair of electrodes.

According to still another aspect of the present invention, a piezoelectric actuator includes a piezoelectric thin film-coated substrate as described above and another electrode that is formed on the side opposite from the electrode with respect to the piezoelectric thin film of the piezoelectric thin film-coated substrate. In this case, it is possible to reliably obtain a structure that allows the piezoelectric thin film to expand and contract according to the applied voltage.

According to a further aspect of the present invention, an inkjet head includes a piezoelectric actuator as described above and a nozzle substrate that has a nozzle orifice through which ink stored in a cavity formed in the substrate of the piezoelectric actuator is ejected to outside. With this structure, because of the high piezoelectric property of the piezoelectric actuator, ink ejection is possible with high-viscosity ink.

According to a further aspect of the present invention, an inkjet printer includes an inkjet head as described above, and ejects the ink from the inkjet head onto a recording medium. Because of the provision of an inkjet head as described above, it is possible to obtain an inkjet printer that is advantageous to high-speed, high-definition printing.

## Industrial Applicability

Ferroelectric thin films according to the present invention find applications in piezoelectric thin film-coated substrates having a piezoelectric thin film formed on a substrate, in piezoelectric actuators incorporating such piezoelectric thin film-coated substrates, in inkjet heads, and in inkjet printers.

## List of Reference Signs

1       inkjet printer
21      inkjet head
21a     actuator (piezoelectric thin film-coated substrate, piezoelectric actuator)
22      substrate
22a     pressure chamber (cavity)
24      lower electrode
25      piezoelectric thin film (ferroelectric thin film)
26      upper electrode
29      seed layer
31      nozzle substrate
31a     ejection orifice (nozzle orifice)
40      piezoelectric thin film-coated substrate
41      substrate
43      lower electrode
44      piezoelectric thin film (ferroelectric thin film)
45      seed layer

## Claims

1. A ferroelectric thin film comprising lead niobate titanate zirconate, wherein
   a ratio "a" of lead to a sum of zirconium, titanium, and niobium is 100% or more by mol ratio,
   a ratio "b" of niobium to the sum of zirconium, titanium, and niobium is 10% or more but 20% or less by mol ratio,
   a ratio "c" of zirconium to a sum of zirconium and titanium is 52% or more but 59% or less by mol ratio, and

a film stress is 100 MPa or more but 250 MPa or less,

**characterized in that** the ratio "a" is 105% or less by mol ratio.

2. The ferroelectric thin film of claim 1, wherein the ratio "c" of zirconium to a sum of zirconium and titanium is 54% or more but 59% or less by mol ratio.

3. The ferroelectric thin film of claim 1 or 2, wherein
the ratio "b" is 15% or more but 19% or less by mol ratio, and
the ratio "c" is 55% or more but 59% or less by mol ratio.

4. The ferroelectric thin film of any one of claims 1 to 3, wherein a crystal orientation of the film is a (100) orientation of a pseudo-cubic crystal.

5. The ferroelectric thin film of any one of claims 1 to 4, wherein a crystal structure of the film is a columnar crystal.

6. The ferroelectric thin film of any one of claims 1 to 5, wherein a film thickness is 1 $\mu$m or more but 10 $\mu$m or less.

7. A piezoelectric thin film-coated substrate having a piezoelectric thin film formed as an upper layer relative to a substrate, wherein the piezoelectric thin film comprises the ferroelectric thin film according to any one of claims 1 to 6.

8. The piezoelectric thin film-coated substrate of claim 7, wherein the substrate comprises a silicon substrate or an SOI substrate.

9. The piezoelectric thin film-coated substrate of claim 7 or 8, wherein a seed layer for controlling crystal orientation of the piezoelectric thin film is disposed between the substrate and the piezoelectric thin film.

10. The piezoelectric thin film-coated substrate of claim 9, wherein the seed layer comprises lead lanthanum.

11. The piezoelectric thin film-coated substrate of any one of claims 7 to 10, wherein an electrode is formed between the substrate and the piezoelectric thin film.

12. A piezoelectric actuator comprising:

the piezoelectric thin film-coated substrate of claim 11; and
another electrode formed on a side opposite from the electrode with respect to the piezoelectric thin film of the piezoelectric thin film-coated substrate.

13. An inkjet head comprising:

the piezoelectric actuator of claim 12; and
a nozzle substrate having a nozzle orifice through which ink stored in a cavity formed in the substrate of the piezoelectric actuator is ejected to outside.

14. An inkjet printer comprising the inkjet head of claim 13, wherein the ink is ejected from the inkjet head onto a recording medium.


**Patentansprüche**

1. Ferroelektrische Dünnschicht umfassend Blei-Niobat-Titanat-Zirkonat, wobei
ein als Molverhältnis angegebenes Verhältnis "a" von Blei zu einer Summe aus Zirkonium, Titan und Niob 100% oder mehr beträgt,
ein als Molverhältnis angegebenes Verhältnis "b" von Niob zur Summe aus Zirkonium, Titan und Niob 10% oder mehr und 20% oder weniger beträgt,
ein als Molverhältnis angegebenes Verhältnis "c" von Zirkonium zu einer Summe aus Zirkonium und Titan 52% oder mehr und 59% oder weniger beträgt, und
die Schichtbelastung 100 MPa oder mehr und 250 MPa oder weniger beträgt,
**dadurch gekennzeichnet, dass** das als Molverhältnis angegebene Verhältnis "a" 105% oder mehr beträgt.

2. Ferroelektrische Dünnschicht nach Anspruch 1, wobei das als Molverhältnis angegebene Verhältnis "c" von Zirkonium zu einer Summe aus Zirkonium und Titan 54% oder mehr und 59% oder weniger beträgt.

3. Ferroelektrische Dünnschicht nach Anspruch 1 oder 2, wobei
das als Molverhältnis angegebene Verhältnis "b" 15% oder mehr und 19% oder weniger beträgt, und
das als Molverhältnis angegebene Verhältnis "c" 55% oder mehr und 59% oder weniger beträgt.

4. Ferroelektrische Dünnschicht nach einem der Ansprüche 1 bis 3, wobei eine Kristallorientierung der Schicht eine (100)-Orientierung eines pseudokubischen Kristalls ist.

5. Ferroelektrische Dünnschicht nach einem der Ansprüche 1 bis 4, wobei eine Kristallstruktur der Schicht ein säulenförmiger Kristall ist.

6. Ferroelektrische Dünnschicht nach einem der Ansprüche 1 bis 5, wobei die Schichtdicke 1 $\mu$m oder mehr und 10 $\mu$m oder weniger beträgt.

7. Piezoelektrische Dünnschicht-beschichtetes Substrat mit einer in Bezug auf ein Substrat als Oberschicht ausgebildeten piezoelektrischen Dünnschicht, wobei die piezoelektrische Dünnschicht die ferroelektrische Dünnschicht nach einem der Ansprüche 1 bis 6 umfasst.

8. Piezoelektrische Dünnschicht-beschichtetes Substrat nach Anspruch 7, wobei das Substrat ein Siliziumsubstrat oder ein SOI-Substrat umfasst.

9. Piezoelektrische Dünnschicht-beschichtetes Substrat nach Anspruch 7 oder 8, wobei eine Keimschicht zum Kontrollieren der Kristallorientierung der piezoelektrischen Dünnschicht zwischen dem Substrat und der piezoelektrischen Dünnschicht angeordnet ist.

10. Piezoelektrische Dünnschicht-beschichtetes Substrat nach Anspruch 9, wobei die Keimschicht Blei-Lanthan umfasst.

11. Piezoelektrische Dünnschicht-beschichtetes Substrat nach einem der Ansprüche 7 bis 10, wobei eine Elektrode zwischen dem Substrat und der piezoelektrischen Dünnschicht ausgebildet ist.

12. Piezoelektrischer Aktor, umfassend:

das piezoelektrische Dünnschicht-beschichtete Substrat nach Anspruch 11; und
eine weitere Elektrode, welche in Bezug auf die piezoelektrische Dünnschicht des piezoelektrische Dünnschicht-beschichteten Substrats auf einer der Elektrode gegenüberliegenden Seite ausgebildet ist.

13. Tintenstrahlkopf, umfassend:

den piezoelektrischen Aktor nach Anspruch 12; und
ein Düsensubstrat mit einer Düsenöffnung, durch welche Tinte, die in einem in dem Substrat des piezoelektrischen Aktors ausgebildeten Hohlraum gelagert ist, nach außen ausgestoßen wird.

14. Tintenstrahldrucker umfassend den Tintenstrahlkopf nach Anspruch 13, wobei die Tinte aus dem Tintenstrahlkopf auf ein Aufzeichnungsmedium ausgestoßen wird.

**Revendications**

1. Film mince ferroélectrique comprenant du zirconate titanate niobate de plomb, dans lequel
un rapport « a » entre le plomb et une somme de zirconium, de titane, et de niobium est de 100 % ou plus en rapport molaire,
un rapport « b » entre le niobium et la somme de zirconium, de titane, et de niobium est de 10 % ou plus mais de 20 % ou moins en rapport molaire,
un rapport « c » entre le zirconium et une somme de zirconium et de titane est de 52 % ou plus mais de 59 % ou moins en rapport molaire, et

une contrainte de film est de 100 MPa ou plus mais de 250 MPa ou moins,
**caractérisé en ce que** le rapport « a » est de 105 % ou moins en rapport molaire.

2. Film mince ferroélectrique selon la revendication 1, dans lequel le rapport « c » entre le zirconium et une somme de zirconium et de titane est de 54 % ou plus mais de 59 % ou moins en rapport molaire.

3. Film mince ferroélectrique selon la revendication 1 ou 2, dans lequel
le rapport « b » est de 15 % ou plus mais de 19 % ou moins en rapport molaire, et
le rapport « c » est de 55 % ou plus mais de 59 % ou moins en rapport molaire.

4. Film mince ferroélectrique selon l'une quelconque des revendications 1 à 3, dans lequel une orientation cristalline du film est une (100) orientation d'un cristal pseudo-cubique.

5. Film mince ferroélectrique selon l'une quelconque des revendications 1 à 4, dans lequel une structure cristalline du film est un cristal colonnaire.

6. Film mince ferroélectrique selon l'une quelconque des revendications 1 à 5, dans lequel une épaisseur de film est de 1 $\mu$m ou plus mais de 10 $\mu$m ou moins.

7. Substrat revêtu d'un film mince piézoélectrique ayant un film mince piézoélectrique formé en tant que couche supérieure par rapport à un substrat, dans lequel le film mince piézoélectrique comprend le film mince ferroélectrique selon l'une quelconque des revendications 1 à 6.

8. Substrat revêtu d'un film mince piézoélectrique selon la revendication 7, dans lequel le substrat comprend un substrat de silicium ou un substrat de SOI.

9. Substrat revêtu d'un film mince piézoélectrique selon la revendication 7 ou 8, dans lequel une couche de germe pour commander l'orientation cristalline du film mince piézoélectrique est disposée entre le substrat et le film mince piézoélectrique.

10. Substrat revêtu d'un film mince piézoélectrique selon la revendication 9, dans lequel la couche de germe comprend du lanthane de plomb.

11. Substrat revêtu d'un film mince piézoélectrique selon l'une quelconque des revendications 7 à 10, dans lequel une électrode est formée entre le substrat et le film mince piézoélectrique.

12. Actionneur piézoélectrique comprenant :

le substrat revêtu d'un film mince piézoélectrique de la revendication 11 ; et
une autre électrode formée sur un côté opposé à l'électrode par rapport au film mince piézoélectrique du substrat revêtu d'un film mince piézoélectrique.

13. Tête à jet d'encre comprenant :

l'actionneur piézoélectrique de la revendication 12 ; et
un substrat buse ayant un orifice de buse à travers lequel de l'encre stockée dans une cavité formée dans le substrat de l'actionneur piézoélectrique est éjectée à l'extérieur.

14. Imprimante à jet d'encre comprenant la tête à jet d'encre de la revendication 13, dans laquelle l'encre est éjectée depuis la tête à jet d'encre sur un support d'enregistrement.

## FIG.1

## FIG.2A

## FIG.2B

21(21a)

27 {
26
25
24
}

23

22 {
22b
22a
}

28

V

## FIG.3

21

27 {
26
25
24
}

23

22 {
22b
22a
}

31

21a

31a

# FIG.4

# FIG.5

# FIG.6

## FIG.7

40

44
45
43
42
41

## FIG.8

52

51

53

50

## FIG.9

Pb$^{2+}$

O$^{2-}$

Ti$^{4+}$ or Zr$^{4+}$ or Nb$^{5+}$

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005072474 A
- JP 2008270704 A
- JP 2008081802 A
- US 2010079555 A
- US 2005146249 A
- JP 2012009677 B